# EUROPÄISCHE PATENTANMELDUNG

(11) **EP 1 980 861 A2**
(43) Veröffentlichungstag der Anmeldung: **15.10.2008**
(21) Anmeldenummer: 08005410.9
(22) Anmeldetag: 22.03.2008
(51) Int. Cl.: G01R 11/04, G01R 22/00, H02H 1/00

(54) **Stromzählersystem mit fernsteuerbarer Stromunterbrechung**

(30) Priorität: 13.04.2007 DE 102007017922
(71) Anmelder: ABB AG, 68309 Mannheim (DE)
(72) Erfinder: Eppe, Klaus-Peter, Dipl.-Ing., 69429 Waldbrunn (DE); Siedelhofer, Bernd, Dipl.-Ing., 69121 Heidelberg (DE); Becker, Joachim, Dipl.-Ing., 68723 Schwetzingen (DE); Muders, Erwin, Dipl.-Ing., 69126 Heidelberg (DE); Wieland, Ralf, Dipl.-Ing., 69429 Waldbrunn (DE)
(74) Vertreter: Miller, Toivo

(57) **Zusammenfassung**

Stromzählersystem (1), umfassend einen elektronischen Stromzähler (2) mit einer Kommunikationsschnittstelle (16), eine Steuerschnittstelle (18), mit der eine Zählerkommunikationsverbindung (20) zwischen dem Zähler und einer entfernt gelegenen Überwachungsstation (22) herstellbar ist und eine Unterbrechungsvorrichtung (4), wobei die Unterbrechungsvorrichtung einen Trennschalter (8), einen durch ein Ansteuersignal fernsteuerbaren Auslöser (24) und eine aus der Nähe betätigbare Rücksetzvorrichtung (26) umfasst, dass der Auslöser auf das Ansteuersignal hin die Öffnung des Trennschalters und die Rücksetzvorrichtung bei ihrer Betätigung das Schließen des Trennschalters bewirken.

## Beschreibung

Die Erfindung betrifft ein Stromzählersystem, umfassend einen elektronischen Stromzähler mit einer Kommunikationsschnittstelle, eine Steuerschnittstelle, mit der eine Zählerkommunikationsverbindung zwischen dem Zähler und einer entfernt gelegenen Überwachungsstation herstellbar ist und eine Unterbrechungsvorrichtung, gemäß dem Oberbegriff des Anspruchs 1, sowie ein Verfahren zur Stromentnahmebegrenzung in einem Stromzählersystem gemäß Anspruch 16.

Gattungsgemäße Stromzählersysteme mit einem elektronischen Haushaltsstromzähler, auch eHZ genannt, und einem Sicherungshauptschalter, auch SH-Schalter genannt, sind im Prinzip bekannt. Elektronische Haushaltszähler verfügen über eine Kommunikationsschnittstelle, mit der beispielsweise eine Fernauslesung des Zählerstandes durch das Energieversorgungsunternehmen, auch EVU genannt, ermöglicht ist. Ein eHZ kann dabei auf eine spezielle Zählertragplatte im Zählerschrank aufgesteckt werden, wobei die elektrische Verbindung mit der Hausinstallationsanlage durch eine Verschiebung des Zählers auf der Zählertragplatte erfolgt.

Bekannt ist es, ein Stromzählersystem gegen unbefugtes Entfernen oder Überbrücken des Zählers zu schützen. In der DE 10 2006 055 322 A1 ist dazu vorgeschlagen, den Stromzähler mit einer Manipulationserkennungsvorrichtung zu versehen, die mit dem SH-Schalter gekoppelt ist. Stellt diese fest, dass der Zähler manipuliert wird, so bewirkt sie über die Kopplung, dass der SH-Schalter zwangsweise ausgeschaltet wird und nur durch befugtes Personal des Energieversorgungsunternehmens (EVU) wieder eingeschaltet werden kann.

Wenn ein Tarifkunde eines EVUs über längere Zeit seine Stromrechnung nicht bezahlt hat, so sperrt ihm in der Regel das EVU nach mehreren erfolglosen Mahnungen die Stromversorgung vollständig, indem im Zählerplatz die Verbindung zur Hausinstallationsanlage unterbrochen und der Zählerplatz plombiert wird. In einigen europäischen Ländern ist es auch üblich, dass das EVU den Zähler einfach aus dem Zählerplatz ausbaut und somit die Stromversorgung zu der Hausinstallationsanlage unterbricht, solange, bis der Kunde seine offenen Rechnungen bezahlt hat. Dieses Verfahren ist jedoch aufwändig, da Personal an die Verbrauchsstelle geschickt werden muss.

Es besteht daher der Wunsch, ein gattungsgemäßes Stromzählersystem so weiterzuentwickeln, dass es bei einfachem und kostengünstigen Aufbau flexibel einsetzbar ist und eine vom EVU aus fernsteuerbare Abschaltung des Stromzählers an der Verbrauchsstelle erlaubt.

Die Aufgabe wird gelöst durch die kennzeichnenden Merkmale des Anspruchs 1.

Erfindungsgemäß also umfasst die Unterbrechungsvorrichtung einen Trennschalter, einen durch ein Ansteuersignal fernsteuerbaren Auslöser und eine aus der Nähe betätigbare Rücksetzvorrichtung, wobei der Auslöser auf das Ansteuersignal hin die Öffnung des Trennschalters und die Rücksetzvorrichtung bei ihrer Betätigung das Schließen des Trennschalters bewirken.

Als erfindungsgemäßer Trennschalter kann jeder beliebige Schalter, der die erforderlichen elektrischen Trenneigenschaften besitzt, verwendet werden, insbesondere natürlich auch ein bekannter SH - Schalter. Durch die erfindungsgemäße Kombination mit einem durch ein Ansteuersignal fernsteuerbaren Auslöser kann der Stromfluss über den Zählerplatz vom EVU aus der Ferne unterbrochen werden, ohne dass Personal vor Ort zu dem einzelnen Zählerplatz geschickt werden muss. Durch die Verwendung von im Prinzip bekannten Trennschaltern, die lediglich noch im Einzelnen an die erfindungsgemäße Verwendung angepasst werden müssen, ist eine kostengünstige Realisierung des erfindungsgemäßen Stromzählersystem möglich. Das Wiedereinschalten des Trennschalters kann erfindungsgemäß nicht ferngesteuert erfolgen, hierzu muss eine Bedienperson vor Ort gehen und von Hand die Rücksetzvorrichtung betätigen. Dies hat den Vorteil, dass das Wiedereinschalten auch von dem Tarifkunden selbst vorgenommen werden kann, nachdem das EVU es ihm erlaubt hat.

Beispielsweise kann die Erlaubnis an die Auflage geknüpft sein, nur wenige Basisverbraucher am Netz zu betreiben und somit nur einen sehr geringen Basisstrom zu beziehen. Das EVU kann die Einhaltung der Auflage durch die Fernabfrage des Zählerstandes jederzeit überprüfen und gegebenenfalls, etwa bei Nichteinhaltung, den Zählerplatz wieder ferngesteuert abschalten. Somit kann durch das erfindungsgemäße Stromzählersystem auch auf einfache und kostengünstige Weise eine Begrenzung des Strombezuges auf einen niedrigen Basisstrom sichergestellt werden. Dieser kann beispielsweise so bemessen werden, dass eine Grundversorgung, beispielsweise für Kühlschrank, Heizung, Notbeleuchtung, und höchstens noch eine Kochplatte, sichergestellt ist, darüber hinausgehende "Luxus"-Verbraucher wie helle Beleuchtung, Computer, Fernseher, etc. jedoch nicht mehr bedient werden können. Eine solche Basisversorgung wäre je nach Wohnungsgröße bei einem erlaubten Strombezug von etwa 1A bis 2A gegeben. Sie könnte bereits nach der ersten erfolglosen Mahnung durchgeführt werden, zu einem früheren Zeitpunkt als die heute übliche Vollsperrung der Versorgung. Erst wenn der Tarifkunde danach immer noch nicht bezahlt, würde der Strom vollständig abgestellt werden.

Gemäß einer besonders vorteilhaften Ausgestaltung der Erfindung umfasst die Unterbrechungsvorrichtung eine durch ein Rücksetzsignal ansteuerbare Rücksetzsteuerung, welche mit der Rücksetzvorrichtung zusammenwirkt und in Abhängigkeit des Rücksetzsignals die Rücksetzvorrichtung zum Rücksetzen entweder freigibt, nicht freigibt oder nur für autorisiertes Personal freigibt. Dies erleichtert dem EVU die Kontrolle, ob die oben erwähnte Bedingung des Bezuges lediglich des geringen Basisstromes seitens des Tarifkunden eingehalten wird. Stellt das EVU beispielsweise eine einmalige Überschreitung des Basisstromes fest, so kann es den Zählerplatz ferngesteuert abschalten, und gleichzeitig das Rücksetzsignal so setzten, dass ein Wiedereinschalten des Trennschalters durch den Tarifkunden erlaubt ist. Bei wiederholtem Überschreiten des Basisstromes kann das Rücksetzsignal dann so gesetzt werden, dass ein Wiedereinschalten des Trennschalters entweder gar nicht mehr oder nur durch autorisiertes Personal möglich ist. Dies ermöglicht es dem EVU, einem säumigen Tarifkunden gegenüber eine Strategie der abgestuften Sanktionen zu fahren.

Eine weitere vorteilhafte Ausführungsform der Erfindung sieht vor, dass zwischen der Überwachungsstation und der Unterbrechungsvorrichtung eine externe Signalverbindung zum Übertragen des Ansteuer- und/oder Rücksetzsignals von der Überwachungsstation direkt zu der Unterbrechungsvorrichtung hin besteht.

Es kann gemäß einer weiteren, ebenfalls sehr vorteilhaften Ausführungsform der Erfindung, auch zwischen der Steuerschnittstelle und der Unterbrechungsvorrichtung eine interne Signalverbindung zum Übertragen des Ansteuer- und/oder Rücksetzsignals von der Steuerschnittstelle zu der Unterbrechungsvorrichtung hin bestehen, so dass die Signalverbindung zwischen der Überwachungsstation und der Unterbrechungsvorrichtung über die Zählerkommunikationsverbindung und die interne Signalverbindung verläuft.

Dabei kann in einer vorteilhaften Weiterbildung der Erfindung eine Steuerschaltung mit einer Auslösebedingungsauswertung vorgesehen sein, die mit der Überwachungsstation und der Unterbrechungsvorrichtung kommunizieren kann, und die auf ein von der Überwachungsstation ausgehendes Aktivierungssignal hin bei Erfüllung der Auslösebedingung das Ansteuer- und/oder Rücksetzsignal für die Unterbrechungsvorrichtung erzeugt. Diese Steuerschaltung kann beispielsweise in der Steuerschnittstelle integriert sein, es kann sich aber auch um eine separate Baugruppe handeln, die im Zählerplatz eingebaut ist.

Vorteilhafterweise umfasst das Stromzählersystem dabei eine Strommesseinrichtung zur Erfassung des über den Zählerplatz fließenden Stromes, die mit der Auslösebedingungsauswertung zusammenwirkt, so dass bei Erreichen eines vorbestimmten Grenzwertes der Stromstärke die Auslösebedingung erfüllt ist. Auf diese Weise kann im Stromzählersystem selbst auf automatische Weise das Einhalten der Auflage über den Bezug eines begrenzten Basisstromes überwacht und sichergestellt werden. Durch das Aktivierungssignal teilt das EVU beispielsweise dem Zählerplatz mit, dass nur ein begrenzter Basisstrom bezogen werden darf. Die Auslösebedingungsauswertung im Zählerplatz überwacht daraufhin, ob der von der Strommesseinrichtung gemessene Stromwert größer ist als der erlaubte Basisstrom. Tritt dieser Fall ein, so ist die Auslösebedingung erfüllt, und die Steuerschaltung setzt das Ansteuersignal für die Unterbrechungsvorrichtung ab, so dass der Auslöser den Trennschalter in der Unterbrechungsvorrichtung öffnet. Wenn das Rücksetzsignal so gesetzt ist, dass ein Wiedereinschalten durch den Tarifkunden erlaubt ist, so kann der Tarifkunde, nachdem er überzählige Verbraucher abgeschaltet hat, den Trennschalter wieder von Hand über die Rücksetzvorrichtung schließen und mit dem Bezug des erlaubten Basisstromes fortfahren. Allerdings nur solange, bis der Wert des bezogenen Stromes wieder den erlaubten Basisstrom überschreitet, dann wird erneut unterbrochen.

Über die Zählerkommunikationsverbindung kann der in der Steuerschaltung hinterlegte Grenzwert für den erlaubten Basisstrombezug vom EVU aus einfach geändert werden. So könnte es beispielsweise bei lange Zeit nicht zahlenden Tarifkunden stufenweise bis auf 0 herabgesetzt werden. In diesem Extremfall ist dann ebenfalls kein manuelles Wiedereinschalten des Trennschalters durch den Kunden vor Ort mehr möglich.

Die erfindungsgemäße Strommesseinrichtung kann dabei der Stromsensor des Stromzählers selbst oder ein in der Unterbrechungsvorrichtung angeordneter weiterer Stromsensor sein.

In einer sehr vorteilhaften Ausführungsform umfasst die Unterbrechungsvorrichtung einen prinzipiell bekannten Sicherungshauptschalter mit einem Schaltgriff zum manuellen Ein - und Ausschalten eines Trennkontaktes des Sicherungshauptschalters, und mit einer Verklinkungsstelle, wobei bei entklinkter Verklinkungsstelle der Trennkontakt geöffnet ist und sich durch den Schaltgriff nicht mehr schließen lässt, sowie mit einem Auslösehebel, der von einer Verklinkungs- in eine Entklinkungsstellung bringbar ist und in der Entklinkungsstellung die Verklinkungsstelle entklinkt, und das Stromzählersystem umfasst weiter einen durch das Ansteuersignal ansteuerbaren Arbeitsstromauslöser, wobei ein Auslöseorgan des Arbeitsstromauslösers direkt mit dem Auslösehebel des Sicherungshauptschalters zusammenwirkt. Dies ist eine Realisierungsform eines erfindungsgemäßen Stromzählersystems, das auf einer erfindungsgemäßen Kombination von im Grunde bekannten Komponenten aufbaut und daher die erfindungsgemäß neue Funktionalität auf sehr kostengünstige Art und Weise herstellt.

In einer anderen vorteilhaften Ausführungsform der Erfindung umfasst die Unterbrechungsvorrichtung einen abgewandelten Sicherungshauptschalter mit einem Schaltgriff zum manuellen Ein - und Ausschalten eines Trennkontaktes des Sicherungshauptschalters, und mit einer Verklinkungsstelle, wobei bei entklinkter Verklinkungsstelle der Trennkontakt geöffnet ist und sich durch den Schaltgriff nicht mehr schließen lässt, sowie mit einem Auslösehebel, der von einer Verklinkungs- in eine Entklinkungsstellung bringbar ist und in der Entklinkungsstellung die Verklinkungsstelle entklinkt, sowie mit einem durch das Ansteuersignal und /oder das Rücksetzsignal ansteuerbaren elektronischen Auslöser, der mit dem Auslösehebel zusammenwirkt. Der Vorteil dieser Ausführungsform liegt in der erweiterten Flexibilität der Anwendung. Der elektronische Auslöser kann so gestaltet sein, dass er auf ein entsprechendes Rücksetzsignal hin die dauerhafte Blockierung der Rücksitzvorrichtung nach der einmaligen Auslösung des SH-Schalters bewirkt. Dieser könnte dann von dem Tarifkunden nicht wieder eingeschaltet werden. Auf ein entsprechend anderes Rücksetzsignal hin kann der elektronische Auslöser diese Blockierung dann wieder freigegeben, so dass dann der Kunde selbst den SH-Schalter wieder von Hand einschalten kann.

Eine weitere vorteilhafte Ausführungsform der Erfindung sieht eine bidirektionale Kommunikation zwischen dem Zähler und der Überwachungsstation vor, welche auf verschiedene Arten realisiert sein kann, beispielsweise über eine Fernwirkverbindung oder über GSM oder über das Stromnetz selbst, die so genannte "Powerline-Kommunikation".

Innerhalb des Zählerplatzes kann gemäß einer weiteren Vorteil auf den Ausführungsform das Ansteuersignal und/oder das Rücksetzsignal zwischen der Steuerschnittstelle und der Unterbrechungsvorrichtung drahtlos übertragen werden. Dies setzt voraus, das entsprechende Kommunikationseinrichtungen für drahtlose Signalübertragung im Nahbereich, wie sie heute bereits erhältlich sind, beispielsweise nach dem Bluetooth- oder dem NFC (Near Field Communication) - Standard, in der Steuerschnittstelle und der Unterbrechungsvorrichtung eingebaut sind. Der Vorteil dieser Ausführungsformen liegt in der vereinfachten Installation, da keine Signalleitungen im Zählerplatz mehr gelegt werden müssten.

Weitere vorteilhafte Ausgestaltungen und Verbesserungen der Erfindung und weitere Vorteile sind den Unteransprüchen zu entnehmen.

Anhand der Zeichnungen, in denen sechs Ausführungsbeispiele der Erfindung dargestellt sind, sollen die Erfindung sowie weitere vorteilhafte Ausgestaltungen und Verbesserungen der Erfindung näher erläutert und beschrieben werden.

Es zeigen:
- Figur 1:: eine erste Ausführungsform eines erfindungsgemäßen Stromzählersystems mit bidirektionaler Kommunikationsverbindung zwischen dem Zähler und der Überwachungsstation und einer externen Signalverbindung zwischen der Überwachungsstation und der Unterbrechungsvorrichtung;
- Figur 2:: eine zweite Ausführungsform eines erfindungsgemäßen Stromzählersystems mit einer zusätzlichen Rücksetzsteuerung in der Unterbrechungsvorrichtung;
- Figur 3:: eine dritte Ausführungsform eines erfindungsgemäßen Stromzählersystems mit einer internen Signalverbindung zwischen der Steuerschnittstelle und der Unterbrechungsvorrichtung;
- Figur 4:: eine vierte Ausführungsform eines erfindungsgemäßen Stromzählersystems mit einer zusätzlichen Steuerschaltung mit Auslösebedingungsauswertung als Teil der Steuerschnittstelle sowie einem zusätzlichen Stromsensor in der Unterbrechungsvorrichtung;
- Figur 5:: eine fünfter Ausführungsform eines erfindungsgemäßen Stromzählersystems mit einem SH-Schalter mit angekoppeltem Arbeitsstrom-Auslöser als Unterbrechungsvorrichtung, sowie

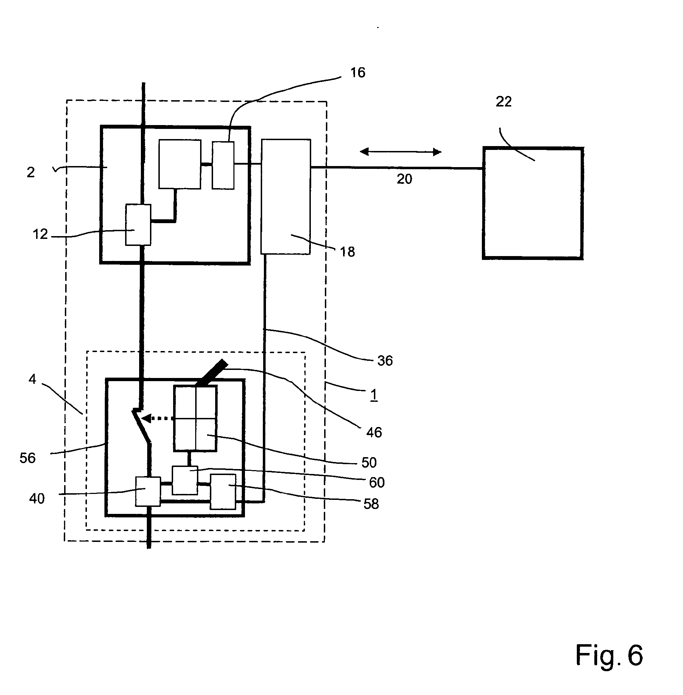

- Figur 6:: eine sechste Ausführungsform eines erfindungsgemäßen Stromzählersystems mit einem SH-Schalter mit elektronischem Auslöser als Unterbrechungsvorrichtung.

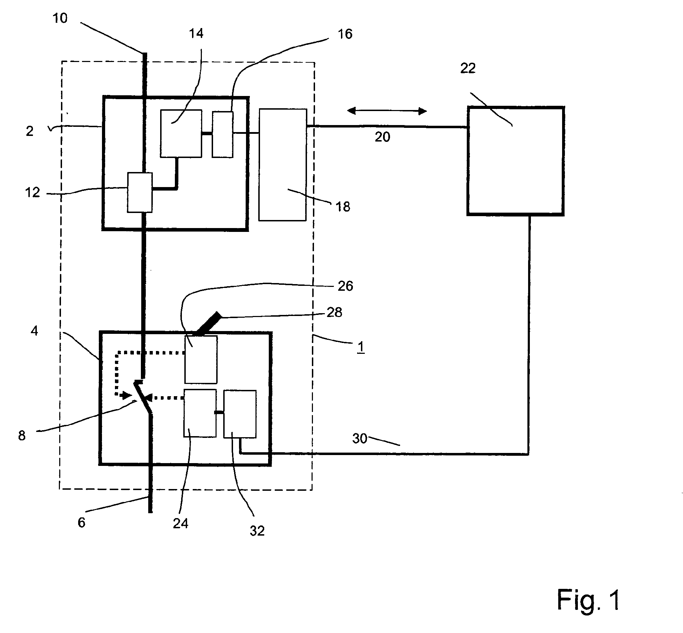

In der Figur 1 ist ein erfindungsgemäßes Stromzählersystem 1 gezeigt, dessen Systemgrenzen durch das strichlierte Rechteck dargestellt sind. Die Systemgrenzen sind weitgehend ähnlich denen von bekannten Zählerplätzen. Das Stromzählersystem 1 umfasst einen elektronischen Haushaltszähler 2 und eine Unterbrechungsvorrichtung 4. Von dem Hausanschlusspunkt der Elektroinstallation führt eine Stromzuleitung 6 in das Stromzählersystem und die Unterbrechungsvorrichtung 4. Dort läuft der Strompfad über einen Trennschalter 8, verlässt die Unterbrechungsvorrichtung 4, tritt in den Zähler 2 ein und verlässt diesen wieder an der Abgangsleitung 10, welche weiter zum Verteilerkasten und den nachgeordneten Schaltkreisen führt.

Der Zähler 2 umfasst in prinzipiell bekannter Weise eine Stromesseinrichtung 12, welche beispielsweise durch einen Hall-Sensor realisiert sein kann, eine Messwertbe- und Verarbeitungseinheit 14 sowie eine Kommunikationsschnittstelle 16.

Weiterhin ist in dem Stromzählersystem 1 einer Steuerschnittstelle18 vorhandenen. Diese ist intern mit der Kommunikationsschnittstelle 16 des Zählers 2 verbunden, und stellt weiterhin die Kommunikationsschnittstelle des Stromzählersystems 1 nach außen hin her. In dem Beispiel der Figur 1 ist sie über eine bidirektionale Kommunikationsverbindung 20, die hier so genannte Zählerkommunikationsverbindung, mit einer entfernt gelegenen Überwachungsstation 22 verbunden. Die Überwachungsstation 22 kann dabei beispielsweise ein Steuer - und Überwachungsrechner bei dem Energieversorgungsunternehmen sein. Die Zählerkommunikationsverbindung 20 ist in Ansicht bekannter Art und Weise aufgebaut, beispielsweise als Fernwirkverbindung, über die Telefonleitung oder ein GSM-Netz oder auch direkt über das Stromnetz, was als "Powerline-Kommunikation" bekannt ist.

Die Unterbrechungsvorrichtung 4 umfasst neben dem Trennschalter 8 noch einen Auslöser 24, welcher mit dem Trennschalter in Wirkverbindung steht, angedeutet durch den strichlierten Pfeil zwischen dem Auslöser 24 und dem Trennschalter 8, und bei entsprechender Auslösung den Trennschalter 8 öffnet. Weiterhin umfasst die Unterbrechungsvorrichtung 4 eine Rücksetzvorrichtung 26, welche ebenfalls in Wirkverbindung mit dem Trennschalter 8 steht - wieder angedeutet durch einen strichlierten Pfeil zwischen der Rücksetzvorrichtung 26 und dem Trennschalter 8. Die Rücksetzvorrichtung 26 kann nur durch ein Betätigungselement 28 betätigt werden, das heißt, zur Betätigung der Rücksetzvorrichtung muss ein Bediener zu dem Stromzählersystem 1 gehen und von Hand die Rücksetzvorrichtung 26 betätigen. Bei Betätigung über das Betätigungselement 28 bewirkt die Rücksetzvorrichtung 26, dass der vorher geöffnete Trennschalter 8 wieder geschlossen wird.

Zwischen der Überwachungsstation 22 und der Unterbrechungsvorrichtung 4 besteht eine externe Signalverbindung 30, über die ein Ansteuersignal für den Auslöser von der Überwachungsstation 22 aus übermittelt werden kann. Die externe Signalverbindung 30 kann, wie die Zählerkommunikationsverbindung 20, auf verschiedene im Prinzip bekannte Arten realisiert sein, insbesondere auch als Fernwirkverbindung, über die Telefonleitung oder ein GSM-Netz oder als "Powerline-Kommunikation". Das Ansteuersignal, welches über die externe Signalverbindung 30 übertragen wird, kann im einfachsten Falle ein binäres Signal sein, in komplizierteren Varianten ist auch eine bidirektionale Signalverbindung denkbar, über die Datenpakete ausgetauscht werden, die weitere Informationen enthalten können. Es kann sich dabei beispielsweise um Status-oder Zustandsinformationen handeln, die von der Unterbrechungsvorrichtung 4 an die Überwachungsstation 22 zurückübertragen werden und über die aus der Ferne der Zustand der Unterbrechungsvorrichtung überwacht werden kann. Hierzu umfasst die Unterbrechungsvorrichtung 4 noch eine Kommunikationsschnittstelle 32, welche im einfachsten Fall eine einfache binäre I/O-Schnittstelle ist.

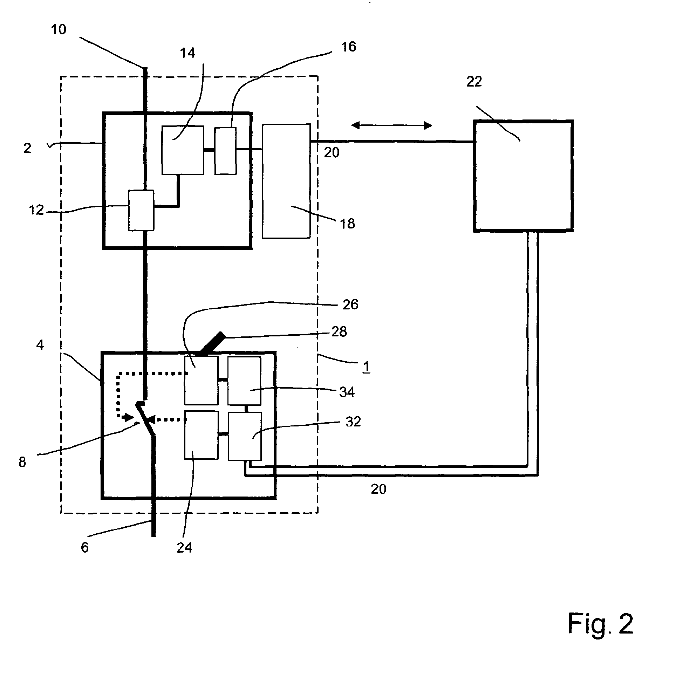

Die Ausführungsform, welche in der Figur 2 gezeigt ist, unterscheidet sich von derjenigen der Figur 1 dadurch, dass in der Unterbrechungsvorrichtung 4 zusätzlich noch eine Rücksetzsteuerung 34 enthalten ist. Diese kann über die Kommunikationsschnittstelle 32 von der Überwachungsstation 22 aus angesprochen werden und steht in Wirkverbindung mit der Rücksetzvorrichtung 26. über die externe Signalverbindung 30 wird nun neben dem Ansteuersignal auch noch ein Rücksetzsignal für die Rücksetzsteuerung 34 übermittelt. Beide werden in der Kommunikationsschnittstelle 32 getrennt und entsprechend an die Rücksetzsteuerung 34 beziehungsweise den Auslöser 24 weitergeleitet.

Die Rücksetzsteuerung 34 wirkt so mit der Rücksetzvorrichtung 26 zusammen, dass sie eine Betätigung der Rücksetzvorrichtung 26 über das Betätigungselement 28 entweder zulässt, blockiert, oder nur für autorisiertes Personal zulässt, jeweils in Abhängigkeit von dem übermittelten Rücksetzsignal. Dadurch kann in der Überwachungsstation 22 entschieden werden, ob dem Tarifkunden ein Wiedereinschalten des Trennschalters 8 am Ort des Stromzählersystems nach einer Auslösung gestattet sein soll oder nicht, oder ob er gezwungen sein soll, autorisiertes Personal des EVU zum Wiedereinschalten anzufordern.

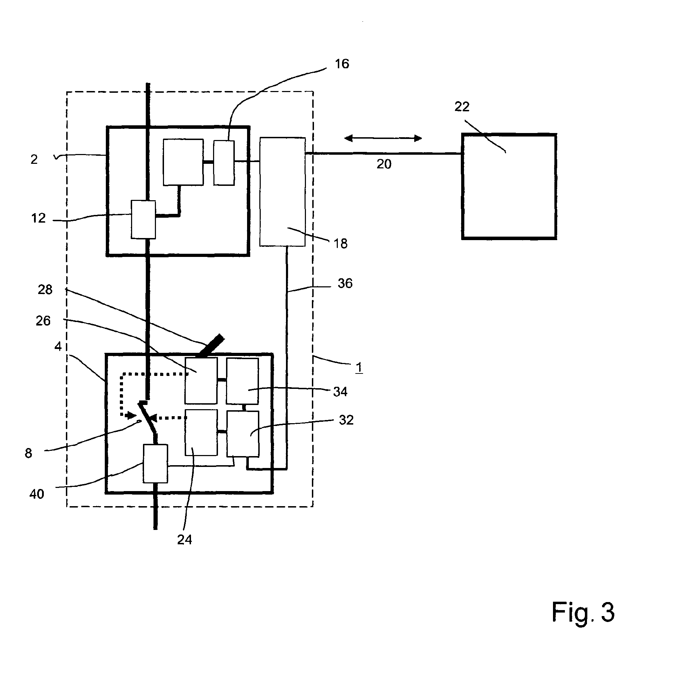

In der Ausführungsform gemäß der Figur 3 ist eine interne Signalverbindung 36 zwischen der Steuerschnittstelle 18 und der Unterbrechungsvorrichtung 4 vorhandenen, anstelle der externen Signalverbindung 30. Hier benutzt der Kommunikationsweg zwischen der Überwachungsstation 22 und der Unterbrechungsvorrichtung 4 die sowieso vorhandene Zählerkommunikationsverbindung 20 zwischen der Überwachungsstation 22 und der Steuerschnittstelle 18, sowie die interne Signalverbindung 36. Der Vorteil dieser Ausführungsform liegt in einer Reduktion der externen Systemschnittstellen der Kommunikation, denn es ist nunmehr nur noch eine externe Kommunikationsschnittstelle über die Zählerkommunikationsverbindung 20 nötig.

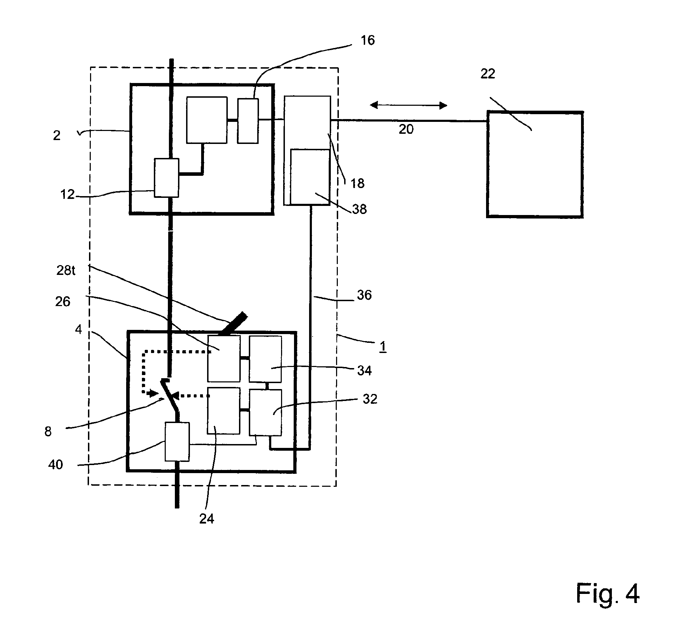

Die Ausführungsform gemäß der Figur 4 hat als zusätzlichen Aspekt eine Steuerschaltung 38 mit einer Auslösebedingungsauswertung. Die Steuerschaltung 38 ist hier als Teil der Steuerschnittstelle 18 realisiert. Es könnte sich aber auch um eine von der Steuerschnittstelle 18 separate Baugruppen innerhalb des Stromzählersystems 1 handeln. Weiterhin umfasst die Unterbrechungsvorrichtung 4 einen Stromsensor 40, der den durch das Stromzählersystem 1 fließenden Strom am Ort der Unterbrechungsvorrichtung 4 erfasst und diesen Wert über die Kommunikationsschnittstelle 33 der Steuerschaltung 38 zur Verfügung stellt. Dadurch ist es nun möglich, die Auslösung des Trennschalters 8 von einer Bedingung abhängig zu machen. Diese Bedingung könnte zum Beispiel sein, dass der von dem Tarifkunden über das Stromzählersystem 1 bezogene Strom einen vorher festgelegten Basiswert, zum Beispiel 2 A, überschreitet. Der Basis wird ist in der Steuerschaltung 38 hinterlegt. Er kann dort von der Überwachungsstation 22 aus über die Zählerkommunikationsverbindung 20 auch jederzeit geändert werden.

Im normalen Betriebszustand würde die Unterbrechungsvorrichtung 4 nicht auslösen, und der Tarifkunde könnte die von ihm benötigte Strommenge unbegrenzt entnehmen. Wenn nun aber der Tarifkunde seine Stromrechnung nicht bezahlt, so könnte das EVU ihm dem Bezug von Strom auf den festgelegten Basiswert beschränken, um ihn zu einer baldigen Begleichung seiner Stromrechnung zu motivieren. Das EVU würde dann über die Zählerkommunikationsverbindung 20 ein einfaches Aktivierungssignal an die Steuerschaltung 38 senden. Diese würde daraufhin von dem Stromsensor 40 den jeweils aktuellen Stromverbrauchswert abrufen. Wenn dieser den vorgegebenen Basiswert übersteigt, würde die Steuerschaltung ein Ansteuersignal für den Auslöser 24 erzeugen, woraufhin dieser den Trennschalter 8 öffnet.

Von der Überwachungsstation 22 wird gleichzeitig ein Rücksetzsignal für die Rücksetzsteuerung 34 gesendet, welches festlegt, ob der Tarifkunde die Rücksetzvorrichtung 36 selbst wieder einschalten darf oder nicht, oder ob er zu autorisiertes Personal vom EVU anfordern muss. Wenn dem Tarifkunden das einschalten erlaubt ist, so wird er das tun, sobald er überflüssige Verbraucher in seinen dem Stromzählersystem 1 nachgeschalteten Stromkreisen abgeschaltet hat, so dass der von ihm bezogene Strom wieder geringer als der festgelegte Basiswert ist. Bei erneutem Überschreiten des Basis-Stromwert es wird der Trennschalter 8 wieder geöffnet, und so weiter. Somit kann auf ein einmalig vom EVU zu dem Stromzählersystem 1 abgesetztes Aktivierungssignal hin der Strombezug des entsprechenden Tarifkunden dauerhaft auf einen bestimmten Basiswert begrenzt werden. Das erfindungsgemäße Stromzählersystem 1 regelt diese Beschränkung des Strombezuges sozusagen selbsttätig.

Selbstverständlich kann auch der in dem Stromzähler 2 sowieso vorhandene Stromsensor 12 zur Erfassung des aktuellen Strombezugswertes verwendet werden, so dass der Einbau eines zusätzlichen Stromsensors 40 in die Unterbrechungsvorrichtung 4 entfallen kann.

Eine weitere Variante besteht darin, dass das EVU den festgelegten Basiswert schrittweise bis auf null reduziert. In diesem Fall wäre dann ein Wiedereinschalten des Trennschalters 8 dauerhaft unterbunden, auch wenn die Rücksetzsteuerung 34 so eingestellt sein sollte, dass ein Wiedereinschalten im Prinzip möglich sein sollte. Denn jedes Mal, wenn der Bediener über das Betätigungselemente 28 die Rücksetzvorrichtung 36 betätigen will, würde beim kleinsten Stromfluss die Steuerschaltung 38 sofort das Ansteuersignal erzeugen und der Auslöser 24 würde den Trennschalter 8 sofort wieder öffnen. Bei dieser Variante könnte man dann sogar auf die Rücksetzsteuerung 34 verzichten.

Weiterhin kann die Abschaltung oder Beschränkung des Strombezuges von dem EVU aus auch dann in dem erfindungsgemäßen Stromzählersystem 1 aktiviert werden, wenn andere Gründe vorliegen, die dieses rechtfertigen. Solche Gründe könnten beispielsweise Netzstörungen sein oder Versorgungsengpässe. Dann kann es nämlich im Sinne der Verbraucher günstiger sein, den Bezug von elektrischer Energie auf einen Basiswert zu beschränken, der sich mit der beschränkten Lieferkapazität des EVU noch vereinbaren lässt, anstatt die Stromversorgung komplett zu sperren.

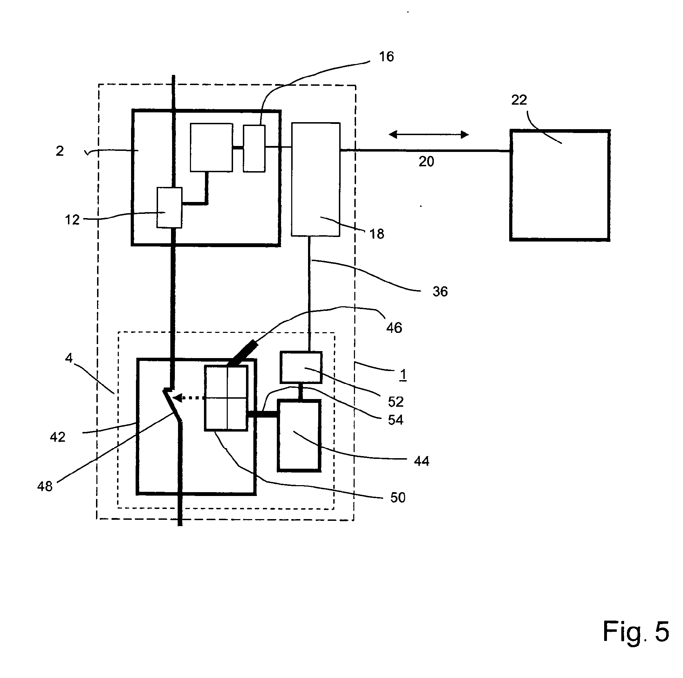

Die Figur 5 zeigt eine Ausführungsform, bei der ein SH-Schalter 42 mit einem angebauten Arbeitsstromauslöser 44 als Unterbrechungsvorrichtung Verwendung findet. Der SH Schalter 42 umfasst, wie prinzipiell bekannt, einen Schaltgriff 46 zum manuellen Ein - und Ausschalten eines Trennkontaktes 48 des Sicherungshauptschalters 42, sowie in einem Schaltwerk 50 eine Verklinkungsstelle, wobei bei entklinkter Verklinkungsstelle der Trennkontakt 48 geöffnet ist und sich durch den Schaltgriff 46 nicht mehr schließen lässt, sowie in dem Schaltwerk 50 weiter einen Auslösehebel, der von einer Verklinkungs- in eine Entklinkungsstellung bringbar ist und in der Entklinkungsstellung die Verklinkungsstelle entklinkt.

Der Arbeitsstromauslöser 44 enthält ein ähnliches Schaltwerk wie der SH-Schalter 42. wenn die Steuerschnittstelle 18 das Ansteuersignal erzeugt, so geht dieses an ein Relais 52, welches daraufhin den Arbeitsstrom für den Arbeitsstromauslöser 44 erzeugt. Der Arbeitsstromauslöser 44 löst dann aus. Die Auslösung des Arbeitsstromauslösers 44 wird durch das Verbindungsorgan 54 auf den Auslösehebel des Schaltwerks 50 in dem SH Schalter 42 übertragen, so dass dieser das Schaltwerk 50 entklinkt. Normalerweise geht der Auslösehebel in dem Schaltwerk 50 nach dem Ausschalten des Trennkontaktes 48 wieder in seine Verklinkungsstellung zurück, so dass ein manuelles Wiedereinschalten des SH Schalters 42 über den Schaltgriff 46 möglich ist. Das Verbindungsorgan 54 kann aber auch so mit dem Auslösehebel zusammenwirken, dass es diesen in seiner Entklinkungsstellung festhält. Dann ist ein Wiedereinschalten des SH Schalters 42 durch den Tarifkunden nicht mehr möglich. Erst eine dazu autorisierte Person kann mit einem Spezialwerkzeug dann in den SH Schalter 42 oder den Arbeitsstromauslöser 44 eingreifen, so dass der Auslösehebels in dem SH Schalter 44 wieder in seine Verklinkungsstellung gelangen kann.

In der Figur sechs schließlich ist eine Variante der Erfindung gezeigt, bei der ein modifizierter SH Schalter 56 verwendet wird. Der modifizierte SH Schalter 56 umfasst zusätzlich eine Kommunikationsschnittstelle 58 und einen elektronischen Auslöser 60. Die Kommunikationsschnittstelle 58 kann im einfachsten Falle eine binäre oder analoge Ein-Ausgabe (I/O) - Schnittstelle sein. Bei dem elektronischen Auslöser 60 kann es sich beispielsweise um ein Piezobiegeelement handeln. Auf das Ansteuersignal hin veranlasst die Kommunikationsschnittstelle 58 den elektronischen Auslöser 60 zur Auslösung, woraufhin dieser den Auslösehebel in dem Schalterwerk 50 des SH Schalters 56 betätigt, so dass der Trennkontakt 48 des SH Schalters 56 geöffnet wird.

Weiterhin kann die Kommunikationsschnittstelle 58 auch noch eine Auslöse Steuerung enthalten, die in Abhängigkeit von dem Ansteuersignal den elektronischen Auslöse 60 veranlasst, nach der Auslösung den Auslösehebel in dem Schaltwerk 50 sofort wieder freizugeben, so dass dieser in seine Verklinkungsstellung zurückfallen kann, oder aber den Auslösehebel in dem Schaltwerk 50 dauerhaft in der Entklinkungsstellung zu halten, so dass ein Wiedereinschalten des SH- Schalters 56 durch den Tarifkunden nicht mehr möglich ist.

**Bezugszeichenliste:**

| | |
|---|---|
| 1 | Stromzählersystem |
| 2 | Stromzähler |
| 4 | Unterbrechungsvorrichtung |
| 6 | Stromleitung vom Hausanschlusspunkt |
| 8 | Trennschalter |
| 10 | Stromleitung zum Verteilerkasten |
| 12 | Stromsensor |
| 14 | Messwert Bearbeitung |
| 16 | Kommunikationsschnittstelle |
| 18 | Steuerschnittstelle |
| 20 | Zählerkommunikationsverbindung |
| 22 | Überwachungsstation |
| 24 | Auslöser |
| 26 | Rücksetzvorrichtung |
| 28 | Betätigungselement |
| 30 | Externe Signalverbindung |
| 32 | Kommunikationsschnittstelle |
| 34 | Rücksetzsteuerung |
| 36 | Interne Signalverbindung |
| 38 | Steuerschaltung mit Auslösebedingungsauswertung |
| 40 | Stromsensor |
| 42 | SH Schalter |
| 44 | Arbeitsstromauslöser |
| 46 | Schaltgriff |
| 48 | Trennkontakt |
| 50 | Schaltwerk |
| 52 | Relais |
| 54 | Verbindungsorgan |
| 56 | SH Schalter |
| 58 | Kommunikationsschnittstelle |
| 60 | Elektronischer Auslöser |

## Patentansprüche

1. Stromzählersystem, umfassend einen elektronischen Stromzähler mit einer Kommunikationsschnittstelle, eine Steuerschnittstelle, mit der eine Zählerkommunikationsverbindung zwischen dem Zähler und einer entfernt gelegenen Überwachungsstation herstellbar ist und eine Unterbrechungsvorrichtung, **dadurch gekennzeichnet, dass** die Unterbrechungsvorrichtung einen Trennschalter, einen durch ein Ansteuersignal fernsteuerbaren Auslöser und eine aus der Nähe betätigbare Rücksetzvorrichtung umfasst, dass der Auslöser auf das Ansteuersignal hin die Öffnung des Trennschalters und die Rücksetzvorrichtung bei ihrer Betätigung das Schließen des Trennschalters bewirken.

2. Stromzählersystem nach Anspruch 1, wobei die Unterbrechungsvorrichtung eine durch ein Rücksetzsignal ansteuerbare Rücksetzsteuerung umfasst, welche mit der Rücksetzvorrichtung zusammenwirkt und in Abhängigkeit des Rücksetzsignals die Rücksetzvorrichtung zum Rücksetzen entweder freigibt, nicht freigibt oder nur für autorisiertes Personal freigibt.

3. Stromzählersystem nach einem der vorigen Ansprüche, wobei zwischen der Überwachungsstation und der Unterbrechungsvorrichtung eine externe Signalverbindung zum Übertragen des Ansteuer- und/oder Rücksetzsignals von der Überwachungsstation zu der Unterbrechungsvorrichtung hin besteht.

4. Stromzählersystem nach einem der Ansprüche 1 oder 2, wobei zwischen der Steuerschnittstelle und der Unterbrechungsvorrichtung eine interne Signalverbindung zum Übertragen des Ansteuer- und/oder Rücksetzsignals von der Steuerschnittstelle zu der Unterbrechungsvorrichtung hin besteht und die Signalverbindung zwischen der Überwachungsstation und der Unterbrechungsvorrichtung über die Zählerkommunikationsverbindung und die interne Signalverbindung verläuft.

5. Stromzählersystem nach Anspruch 4, umfassend eine Steuerschaltung mit einer Auslösebedingungsauswertung, die mit der Überwachungsstation und der Unterbrechungsvorrichtung kommunizieren kann, und die auf ein von der Überwachungsstation ausgehendes Aktivierungssignal hin bei Erfüllung der Auslösebedingung das Ansteuer- und/oder Rücksetzsignal für die Unterbrechungsvorrichtung erzeugt.

6. Stromzählersystem nach Anspruch 5, umfassend eine Strommesseinrichtung zur Erfassung des über den Zählerplatz fließenden Stromes, die mit der Auslösebedingungsauswertung zusammenwirkt, so dass bei Erreichen eines vorbestimmten Grenzwertes der Stromstärke die Auslösebedingung erfüllt ist.

7. Stromzählersystem nach Anspruch 6, wobei die Strommesseinrichtung der Stromsensor des Stromzählers selbst ist.

8. Stromzählersystem nach Anspruch 6, wobei die Strommesseinrichtung in der Unterbrechungsvorrichtung angeordnet ist.

9. Stromzählersystem nach einem der vorigen Ansprüche, wobei die Unterbrechungsvorrichtung einen Sicherungshauptschalter umfasst mit einem Schaltgriff zum manuellen Ein - und Ausschalten eines Trennkontaktes des Sicherungshauptschalters, und mit einer Verklinkungsstelle, wobei bei entklinkter Verklinkungsstelle der Trennkontakt geöffnet ist und sich durch den Schaltgriff nicht mehr schließen lässt, sowie mit einem Auslösehebel, der von einer Verklinkungs- in eine Entklinkungsstellung bringbar ist und in der Entklinkungsstellung die Verklinkungsstelle entklinkt, wobei das Stromzählersystem weiter einen durch das Ansteuersignal ansteuerbaren Arbeitsstromauslöser umfasst, und wobei ein Auslöseorgan des Arbeitsstromauslösers direkt mit dem Auslösehebel des Sicherungshauptschalters zusammenwirkt.

10. Stromzählersystem nach einem der Ansprüche 1 bis 8, wobei die Unterbrechungsvorrichtung einen Sicherungshauptschalter umfasst mit einem Schaltgriff zum manuellen Ein - und Ausschalten eines Trennkontaktes des Sicherungshauptschalters, und mit einer Verklinkungsstelle, wobei bei entklinkter Verklinkungsstelle der Trennkontakt geöffnet ist und sich durch den Schaltgriff nicht mehr schließen lässt, sowie mit einem Auslösehebel, der von einer Verklinkungs- in eine Entklinkungsstellung bringbar ist und in der Entklinkungsstellung die Verklinkungsstelle entklinkt, sowie mit einem durch das Ansteuersignal ansteuerbaren elektronischen Auslöser, der mit dem Auslösehebel zusammenwirkt.

11. Stromzählersystem nach einem der vorigen Ansprüche mit bidirektionaler Kommunikation zwischen dem Zähler und der Überwachungsstation.

12. Stromzählersystem nach einem der vorigen Ansprüche, wobei die Kommunikation zwischen dem Zähler und der Überwachungsstation über eine Fernwirkverbindung oder über GSM oder über Powerline-Kommunikation realisiert ist.

13. Stromzählersystem nach einem der vorigen Ansprüche, wobei das Ansteuersignal und/oder das Rücksetzsignal drahtlos zu der Unterbrechungsvorrichtung übertragbar ist.

14. Stromzählersystem nach einem der vorigen Ansprüche, wobei die externe Signalverbindung und/oder die Interne Signalverbindung für eine bidirektionale Kommunikation zwischen der Unterbrechungsvorrichtung und der Steuerschnittstelle und/oder der Überwachungsstation eingerichtet ist.

15. Stromzählersystem nach Anspruch 14, wobei von der Überwachungsstation aus Status - oder Zustandsinformationen von der Unterbrechungsvorrichtung abfragbar und von dieser zu der Überwachungsstation übermittelbar sind.

16. Verfahren zur Stromentnahmebegrenzung in einem Stromzählersystem gemäß einem der vorigen Ansprüche, **gekennzeichnet durch** die folgenden Schritte:
- Hinterlegen eines Grenzwertes für den entnehmbaren Strom,
- Erfassen des aktuellen Stromverbrauchswertes und Vergleich mit dem hinterlegten Grenzwert,
- Bei Überschreiten des Grenzwertes Erzeugen eines Ansteuersignals für den Auslöser in der Unterbrechungsvorrichtung.

17. Verfahren nach Anspruch 16, wobei der Grenzwert für den entnehmbaren Strom von der Überwachungsstation aus über die Zählerkommunikationsverbindung zu der Steuerschaltung mit Auslösebedingungsauswertung übertragen und dort gespeichert wird.

18. Verfahren nach einem der Ansprüche 16 bis 17, wobei zum Start der Stromentnahmebegrenzung von der Überwachungsstation 23 zu der Steuerschnittstelle 18 ein Aktivierungssignal übertragen wird.
